# EUROPEAN PATENT APPLICATION

(11) **EP 4 722 774 A1**
(43) Date of publication of application: **08.04.2026**
(21) Application number: 25191534.4
(22) Date of filing: 24.07.2025
(51) Int. Cl.: G02B 6/30, G02B 6/42, G02B 6/43

(54) **SYSTEM AND METHODS FOR CO-PACKAGE OPTICS ARCHITECTURE**

(30) Priority: 03.10.2024 US 202418906163
(71) Applicant: Samsung Electronics Co., Ltd., Suwon-si, Gyeonggi-do 16677 (KR)
(72) Inventor: LI, Yan, San Jose, CA, 95134, (US); KIM, WooPoung, San Jose, CA, 95134 (US)
(74) Representative: Kuhnen & Wacker Patent- und Rechtsanwaltsbüro PartG mbB

(57) **Abstract**

Systems, methods and devices disclosed herein may include a substrate (101) having a first attachment location and a second attachment location, a first photonic integrated circuit (110) may be mounted within the first attachment location, and a bridge (108) may be mounted within the second attachment location. A first compute device (102) may be mounted on the substrate (101) and at least partially over the first attachment location and the second attachment location.

## Description

### TECHNICAL FIELD

The subject matter disclosed herein relates to packaging. More particularly, the subject matter disclosed herein relates to a technique for electrically connecting between electronic integrated circuits (EICs) and photonic integrated circuits (PICs).

### BACKGROUND

Semiconductor devices may connect to additional devices and circuitry on different substrates. Forming connections between substrates may provide increased computational power. However, forming connections between substrates may cause difficulties. Packaging describes the general method for connecting and integrating multiple computational components together in an integrated unit, and may involve multiple different types of integrated circuits on multiple substrates which may combine into a single unit. Packaging may also describe a method for which multiple computational components within a single unit are protected by the use of various techniques to provide thermal, physical and electrical protection. It is further noted that background concepts discussed herein are for informational purposes only and are not intended to limit the present disclosure. Nor should the background or field described herein be intended to limit the disclosure herein to a particular use or concept.

### SUMMARY

A device disclosed herein may include a substrate having a first attachment location and a second attachment location, a first photonic integrated circuit may be mounted within the first attachment location, and a bridge may be mounted within the second attachment location. A first compute device may be mounted on the substrate and at least partially over the first attachment location and the second attachment location. In some embodiments, a second compute device may be mounted on the substrate at least partially over the second attachment location, and the second compute device may be electrically connected to the first compute device by the bridge. In some embodiments, the first compute device may include at least one of a memory device and a processing device. In some embodiments, a redistribution layer may be between the first photonic integrated circuit and the first compute device, and an optical fiber connection may extend between a surface of the substrate and the first photonic integrated circuit. In some embodiments, the substrate may include glass or silicon. In some embodiments, the first photonic integrated circuit may include a plug connector for a bi-directional optical fiber, the bi-directional optical fiber able to transmit an incoming optical signal to the first photonic integrated circuit and transmit an outgoing optical signal from the first photonic integrated circuit. In some embodiments, a fluid cooling channel may be formed within the substrate, and a thermal via may be formed between the first attachment location and the surface of the substrate. In some embodiments, a thermal via may thermally couple the first photonic integrated circuit to the fluid cooling channel. In some embodiments, the bridge is a second photonic integrated circuit.

A method disclosed herein may include a substrate having a first side and a second side opposite the first side. The first side may have a first attachment location and a second attachment location. A photonic integrated circuit may be at least partially within the first attachment location, and a bridge may be at least partially within the second attachment location. A first compute device may be mounted on the first side of the substrate. A first thermal via may be within the substrate and may extend from the second side to the first attachment location. In some embodiments, a second compute device may be mounted on the first side of the substrate, and may be coupled to the first compute device via the bridge at least partially within the second attachment location. In some embodiments, an attach film may be between the thermal via and the photonic integrated circuit. In some embodiments, a second thermal via within the substrate may extend from the second side to the second attachment location, and an attach film may between the second thermal via and the bridge. In some embodiments, a fluid cooling channel may be within the substrate and thermally coupled to the first thermal via. In some embodiments, a redistribution layer may be between the photonic integrated circuit and the first compute device, and an optical fiber connection may extend between a surface of the first side of the substrate and a surface of the photonic integrated circuit parallel to the first side. In some embodiments, the first compute device may be mounted at least partially over the first attachment location and the second attachment location.

A method may include preparing a substrate, forming a first attachment location and a second attachment location within a first side of the substrate, mounting a photonic integrated circuit at least partially within the first attachment location, mounting a bridge at least partially within the second attachment location, forming a redistribution layer on the first side of the substrate, and forming an open area in the redistribution layer over the photonic integrated circuit. In some embodiments, a first compute device may be mounted on the redistribution layer and electrically connected to the photonic integrated circuit and the bridge. In some embodiments, a second compute device may be mounted on the redistribution layer and electrically connected to the first compute device via the bridge. In some embodiments, an optical fiber may connect to the photonic integrated circuit via the open area in the redistribution layer. In some embodiments, preparing the substrate may include at least one of forming a thermal via, forming a liquid cooling channel, and forming a through-substrate via. In some embodiments, the optical fiber may connect to a surface of the photonic integrated circuit parallel to the first side of the substrate. In some embodiments, the first compute device may include a first device and a second device, which may include a processing device and a memory device. In some embodiments, forming the first attachment location and the second attachment location within the first side of the substrate may including laser milling a glass substrate.

### BRIEF DESCRIPTION OF THE DRAWING

In the following section, the aspects of the subject matter disclosed herein will be described with reference to exemplary embodiments illustrated in the figures, in which:
FIG. 1 depicts a cross-section view of an example embodiment of a hybrid electronic integrated circuit and photonic integrated circuit system according to various embodiments of the subject matter disclosed herein;
FIG. 2 depicts a plan view of an example embodiment of a hybrid electronic integrated circuit and photonic integrated circuit system according to various embodiments of the subject matter disclosed herein;
FIG. 3 depicts a cross-section view of an example embodiment of a hybrid electronic integrated circuit and photonic integrated circuit system according to various embodiments of the subject matter disclosed herein;
FIG. 4 depicts a cross-sectional view of an example embodiment of a hybrid electronic integrated circuit and photonic integrated circuit system according to various embodiments of the subject matter disclosed herein; and
FIG. 5A depicts a cross-sectional view of an example embodiment of a hybrid electronic integrated circuit and photonic integrated circuit system at a first time according to various embodiments of the subject matter disclosed herein;
FIG. 5B depicts a cross-sectional view of an example embodiment of a hybrid electronic integrated circuit and photonic integrated circuit system at a second time according to various embodiments of the subject matter disclosed herein;
FIG. 5C depicts a cross-sectional view of an example embodiment of a hybrid electronic integrated circuit and photonic integrated circuit system at a third time according to various embodiments of the subject matter disclosed herein;
FIG. 5D depicts a cross-sectional view of an example embodiment of a hybrid electronic integrated circuit and photonic integrated circuit system at a fourth time according to various embodiments of the subject matter disclosed herein;
FIG. 5E depicts a cross-sectional view of an example embodiment of a hybrid electronic integrated circuit and photonic integrated circuit system at a fifth time according to various embodiments of the subject matter disclosed herein;
FIG. 5F depicts a cross-sectional view of an example embodiment of a hybrid electronic integrated circuit and photonic integrated circuit system at a sixth time according to various embodiments of the subject matter disclosed herein;
FIG. 5G depicts a cross-sectional view of an example embodiment of a hybrid electronic integrated circuit and photonic integrated circuit system at a seventh time according to various embodiments of the subject matter disclosed herein;
FIG. 5H depicts a cross-sectional view of an example embodiment of a hybrid electronic integrated circuit and photonic integrated circuit system at an eighth time according to various embodiments of the subject matter disclosed herein;
FIG. 6 depicts an example embodiment of a method according to various embodiments of the subject matter disclosed herein;
FIG. 7 depicts a cross-sectional view of an example embodiment of a hybrid electronic integrated circuit and photonic integrated circuit system according to various embodiments of the subject matter disclosed herein; and
FIG. 8 depicts a plan view of an example embodiment of a hybrid electronic integrated circuit and photonic integrated circuit system according to various embodiments of the subject matter disclosed herein.

### DETAILED DESCRIPTION

In the following detailed description, numerous specific details are set forth in order to provide a thorough understanding of the disclosure. It will be understood, however, by those skilled in the art that the disclosed aspects may be practiced without these specific details. In other instances, well-known methods, procedures, components and circuits have not been described in detail to not obscure the subject matter disclosed herein.

Reference throughout this specification to "one embodiment" or "an embodiment" means that a particular feature, structure, or characteristic described in connection with the embodiment may be included in at least one embodiment disclosed herein. Thus, the appearances of the phrases "in one embodiment" or "in an embodiment" or "according to one embodiment" (or other phrases having similar import) in various places throughout this specification may not necessarily all be referring to the same embodiment. Furthermore, the particular features, structures or characteristics may be combined in any suitable manner in one or more embodiments. In this regard, as used herein, the word "exemplary" means "serving as an example, instance, or illustration." Any embodiment described herein as "exemplary" is not to be construed as necessarily preferred or advantageous over other embodiments. Additionally, the particular features, structures, or characteristics may be combined in any suitable manner in one or more embodiments. Also, depending on the context of discussion herein, a singular term may include the corresponding plural forms and a plural term may include the corresponding singular form. Similarly, a hyphenated term (e.g., "two-dimensional," "pre-determined," etc.) may be occasionally interchangeably used with a corresponding non-hyphenated version (e.g., "two dimensional," "predetermined, etc.), and a capitalized entry (e.g., "Integrated Chip," "First Substrate," "PIC," etc.) may be interchangeably used with a corresponding non-capitalized version (e.g., "integrated chip," "first substrate," "pic," etc.). Such occasional interchangeable uses shall not be considered inconsistent with each other.

Also, depending on the context of discussion herein, a singular term may include the corresponding plural forms and a plural term may include the corresponding singular form. It is further noted that various figures (including component diagrams) shown and discussed herein are for illustrative purpose only, and are not drawn to scale. For example, the dimensions of some of the elements may be exaggerated relative to other elements for clarity. Further, if considered appropriate, reference numerals have been repeated among the figures to indicate corresponding and/or analogous elements.

The terminology used herein is for the purpose of describing some example embodiments only and is not intended to be limiting of the claimed subject matter. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

It will be understood that when an element or layer is referred to as being on, "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numerals refer to like elements throughout. As used herein, the term "and/or" includes any and all combinations of one or more of the associated listed items.

The terms "first," "second," etc., as used herein, are used as labels for nouns that they precede, and do not imply any type of ordering (e.g., spatial, temporal, logical, etc.) unless explicitly defined as such. Furthermore, the same reference numerals may be used across two or more figures to refer to parts, components, blocks, circuits, units, or modules having the same or similar functionality. Such usage is, however, for simplicity of illustration and ease of discussion only; it does not imply that the construction or architectural details of such components or units are the same across all embodiments or such commonly-referenced parts/modules are the only way to implement some of the example embodiments disclosed herein.

Unless otherwise defined, all terms (including technical and scientific terms) used herein have the same meaning as commonly understood by one of ordinary skill in the art to which this subject matter belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Disclosed herein are various devices, structures and methods for forming an optical interconnection between devices including both electronic integrated circuits (EICs) and photonic integrated circuits (PICs). In some embodiments, a hybrid transceiver may use a combination of EICs and PICs to transmit and receive optical signals between devices. In some embodiments, a first hybrid transceiver may bi-directionally communicate with a second hybrid transceiver using an optical interconnection.

As used herein, EICs refer to a wide variety of integrated circuits using electrical components. In some embodiments, EICs may include a combination of various electrical components such as transistors, resistors, inductors, and capacitors which in combination form an electronic circuit on a substrate. In some embodiments, EICs may include central processing units (CPUs), logic chips, memory such as static random-access memory (SRAM), dynamic random-access memory (DRAM), application processors (AP), graphical processing units (GPUs), artificial intelligence (AI) chips, high bandwidth memory (HBM) interfaces, and other application-specific integrated circuits (ASIC). In some embodiments, a combination of circuits may be present on a substrate. In some embodiments, EICs may be referred to in terms such as microchips, microcontrollers, silicon chips.

As used herein, PICs refer to a wide variety of integrated circuits using photonic components. In some embodiments, PICs may include a combination of various photonic components such as waveguides, optical filters, gratings, lenses, mirrors, and optical ring resonators. In some embodiments, PICs may include electrical components such as photodiodes, light emitting diodes, and laser diodes. In some embodiments, PICs may be referred to using terms such as integrated optical circuits, and planar light wave circuits.

As used herein, a substrate may be composed of one or more of a variety of materials and structures, including wafers using silicon, wafers using silicon on an insulator (SOI) such as glass, wafers of other semiconductor materials such as germanium, as well as other semiconductor materials on an insulator. In some embodiments, a substrate may include an organic material. In some embodiments, the substrates may be referred to as wafers, dies, and chips alone or in combination. In some embodiments, a substrate for use in a PIC may be referred to a waveguide. Bonding substrates together may be thus known in some embodiments as die-to-die (D2D) bonding, wafer-to-wafer bonding (W2W) or die-to-wafer bonding (D2W). In some embodiments, a packaged chip may contain multiple substrates, and may include PIC substrates, EIC substrates, or a combination of PIC substrates and EIC substrates. In some embodiments, circuits may be bonded directly facing each other, while in other embodiments a flip-chip bonding may be used. In some embodiments, interconnections may be made between substrates on a front or circuit side of the substrate. In other embodiments, interconnections may be made on a rear or back side of the substrate opposite from the circuit structure. In some embodiments, an interconnection may include through-silicon vias (TSVs) or other forms of through-chip vias where one or more substrates may be connected using a via traveling through an interposer such as another substrate or chip. In some embodiments, an interconnection may be formed using connections on a surface of a substrate, such as a pad, and may use additional materials between the pads such as solder to form an interconnection.

In some embodiments, bonding between substrates may involve bonding between metals, or metal-metal bonding. In some embodiments, bonding between substrates may involve bonding between dielectric materials, or dielectric-dielectric bonding. In some embodiments, bonding between substrates may involve both metal-metal and dielectric-dielectric bonding, known as hybrid bonding. A hybrid bonding technique may be used to provide additional connections between opposing surfaces, allowing both dielectric and conductive surfaces to bond, and may increase the mechanical strength of the resulting structure. As used herein, hybrid bonding may be defined as bonding both conductive portions to conductive portions, such as a metal-metal bond, and bonding dielectric portions to dielectric portions such as a dielectric-dielectric bond.

As used herein, multiplexing may refer to a number of techniques for multiplexing optical signals. In some embodiments, multiplexing may refer to wavelength division multiplexing (WDM). In some embodiments, the multiplexing may refer to polarization-based multiplexing. In some embodiments, the multiplexing may refer to optical fiber mode based polarization. In some embodiments, multiplexing may be a combination of one or more of WDM, polarization, and fiber mode polarization.

As used herein, polarization may refer to both linear and circular polarization. Linear polarization modes may be referred to as S and P or transverse-magnetic (TM) and transverse-electric (TE) polarizations. Circular polarizations may be referred to as right-handed polarization (RCP) or left-handed polarization (RCP).

As used herein, conductors may refer to a variety of conductive materials, including which materials may be used alone or in combination with other materials such as in the form of an alloy. In some embodiments the conductor is copper (Cu). In some embodiments, copper (Cu) may be in the form of Cu (II), Cu (III) or other forms of copper, alone or in combination with additional elements, including cobalt (Co) and ruthenium (Ru). Such a listing of elements is not intended to be exhaustive, and in other embodiments, any known other type of conductive material may be used.

As used herein, a device stack or stack of devices may refer to a combination of memory and supporting circuit architecture, for example, chiplets and dies containing individual memory elements, supporting processing units, input output (I/O) circuitry, and other forms of integrated chips. As used herein, a chiplet may refer to an integrated circuit having a well-defined functionality, such as a microprocessor, a memory device, or other computational function; with a chiplet enabling a modular design with multiple chiplets able to be combined with a larger package, sharing a substrate or interposer to form a larger device. A core may refer to a single-unit of a multicore device where multiple devices form a larger device, with each device able to function independently to enable multiple streams of operations. In some embodiments, a core may take the form of a chiplet, or a chiplet may take the form of a core. However, in other embodiments, a chiplet may take the form of any other suitable integrated circuit.

As used herein, a bridge refers to a substrate, die, or other material having one or more electrically conductive pathways able to form connection between one or more semiconductor devices, as well as substrates, interposers, or other package structures. A bridge may include one or more electrically conductive traces forming a connection pathway along the bridge between one or more devices coupled to the bridge. An embedded bridge, as used herein, may refer to a bridge in a layer within a semiconductor package, and may be used interchangeably with bridge. An active bridge may refer to a bridge featuring additional features beyond connections, such as transistors, vias, and other circuit components.

As used herein, an attachment location refers to a location where a die, substrate, compute device, interposer, or other device may be attached to a substrate. In some embodiments, the attachment location may take the form of a cavity, recess, hole, opening, depression, pit, orifice pocket, hollow, space, socket, gap, or some combination thereof. As used herein, attachment location may be used interchangeably with cavity. In some embodiments, the attachment location may take the form of a surface mounting built on a planar surface of a substrate, a surface structure built upon a substrate, or a combination with a cavity.

Disclosed herein are various embodiments of systems, methods and devices using co-packaging both EIC and PIC on a substrate. In various embodiments, the substrate may be a glass core substrate, a silicon substrate, or a substrate formed of any other suitable semiconductor material. In various embodiments disclosed herein, a PIC may be embedded at least partially within a cavity of the substrate. In some embodiments, an EIC may also be embedded at least partially within a cavity of the substrate. In some embodiments, a process such as milling may open a cavity within the substrate for mounting at least one EIC and PIC. A redistribution layer may be mounted at least partially on an EIC or PIC embedded at least partially within a cavity of the substrate. The redistribution layer may support and couple to one or more additional devices, such as memory devices, processing devices, ASICs, and stacks including combinations such as HBMs. A fiber attach unit (FAU) may be directly connected to the PIC embedded at least partially within a cavity of the substrate via an opening in the redistribution layer. A signal may be received by the FAU and transmitted to the PIC embedded at least partially within a cavity of the substrate before being transmitted via the redistribution layer to the one or more additional devices.

In some embodiments, the substrate may have thermal features such as vias, heat sinks, and fluidic cooling channels. In some embodiments, the thermal features may provide for heat transfer of the PIC, the EIC, and any additional devices mounted to the substrate. In some embodiments, the thermal features may be formed on the substrate prior to forming a cavity for the placement of an EIC or PIC. In some embodiments, one or more through-vias may be formed on the substrate prior to forming a cavity for the placement of an EIC or PIC. In some embodiments, the one or more though-vias may be a through glass via (TGV) within a glass substrate, a through silicon via (TSV) within a silicon substrate, or other suitable via within any other substrate.

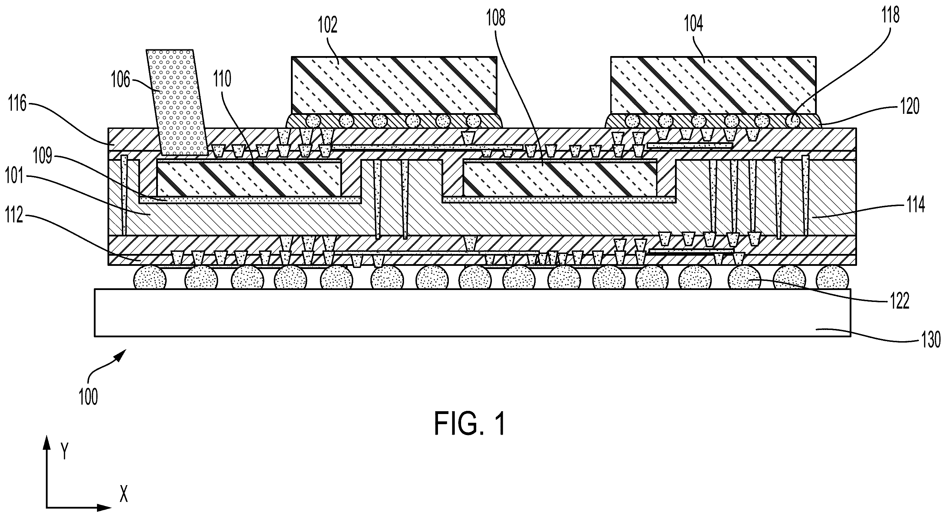

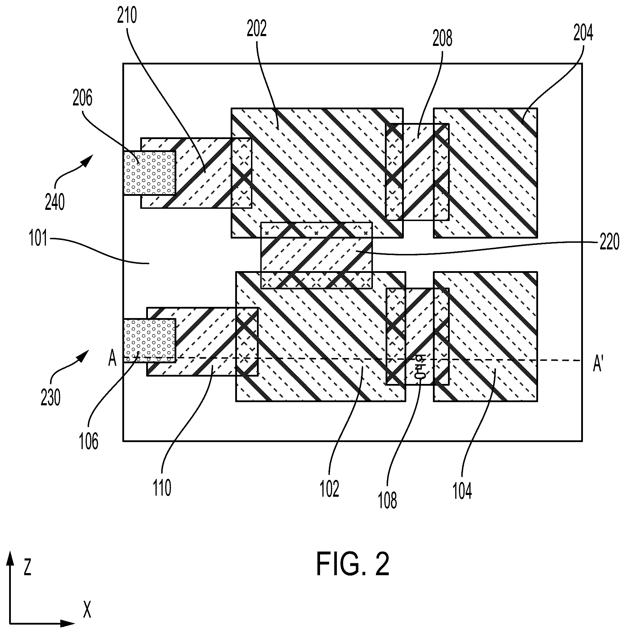

FIG. 1 discloses an exemplary embodiment of an architecture for a device package architecture 100 formed on a substrate 101. In some embodiments, the substrate 101 includes one or more devices (also referred to herein as "compute devices") mounted thereupon. In the exemplary embodiment of FIG. 1, a first device 102 and a second device 104 are mounted upon the substrate 101. In some embodiments, the substrate 101 may comprise a glass substrate, a glass core substrate, a silicon substrate, or another other suitable substrate. In some embodiments, the devices of the first device 102 and the second device 104 may be various forms of devices such as memory including DRAM, SRAM, and other forms of memory; a processor including CPU, XPU, GPUs; as well as additional suitable circuits, including ASICs, or combinations thereof. In some embodiments, the first device 102 and the second device 104 may each comprise a stack of one or more component devices. In some embodiments, the stack of component devices may include one or more memory devices, core devices, and combinations thereof. In some embodiments, a core device may include for example a processor, processing device, or other form of microcontroller to act as a controller. While the exemplary embodiment of FIG. 1 depicts only a first device 102 and a second device 104, the device package architecture 100 may include additional devices, for example, as discussed with respect to FIG. 2 below.

The substrate 101 may have the first device 102 and the second device 104 mounted thereon in a variety of ways and may include pads, bumps, microbumps, pillars, balls, ball grids, microball arrays, and other forms such as controlled-collapse chip connection (C4) bumps, alone or in combination. As used herein, a C4 bump refers to a form of solder bumps placed on pads on a top surface of a substrate prior to flipping the substrate to form a flip-chip. The mounting method may further include a dielectric material, which may include a material such as an adhesive, resin, or elastomer which may form a connection in addition to a conductive connection. In some embodiments, the combination of a conductive connection and a dielectric connection may form a hybrid bond. The first device 102 is at least partially over the first attachment location and the second attachment location, and the second device 104 is at least partially over the second attachment location.

In some embodiments, substrate 101 may also include one or more integrated circuits embedded within the surface of the substrate 101. In the exemplary embodiment of FIG. 1, a first PIC 110 is embedded within a cavity formed on the surface of the substrate 101. The first PIC 110 may, in some embodiments, be mounted on an attach film 109 located between the first PIC 110 and the substrate 101. In some embodiments, the attach film 109 may be formed from an adhesive material such as a resin or epoxy, a metal layer, a dielectric material, or any other suitable material to form one or more layers to allow the first PIC 110 or an embedded bridge 108 to mount on the substrate 101. In some embodiments, the embedded bridge 108 may be embedded within the surface of the substrate 101, and in some embodiments may include the attach film 109 between the embedded bridge 108 and the substrate 101. In some embodiments, the embedded bridge 108 may be a PIC, while in other embodiments, the embedded bridge 108 may be an EIC, a die, a passive bridge, or some other suitable element for forming a connection between two circuits, or in a combination thereof. Exemplarily, the second device 104 is electrically connected to the first device 102 by the bridge 108.

In some embodiments, a first optical connection 106 may connect to the first PIC 110. In some embodiments, the first optical connection 106 may be a fiber optic, an optical connector, a FAU, a pluggable optical connector, a plug connector, a v-groove, as well as combinations thereof and various arrays thereof. For example, the first PIC may include a plug connector configured to receive a bi-directional optical fiber. In some embodiments, the optical fiber may be unidirectional, allowing only transmitting or receiving, while in other embodiments, the optical fiber may be a bi-directional fiber. In some embodiments, additional optical elements may be placed between the first optical connection 106 and the first PIC 110, such as polarizers, gratings, anti-reflection coatings, filters, index matching coatings, lenses, and any other suitable optical components, alone or in a combination thereof. In some embodiments, the first optical connection 106 may allow the device package architecture 100 to transmit optical signals, to receive optical signals, or both receive and transmit optical signals. In some embodiments, the first optical connection 106 may include a plurality of optical connections, including a receiving optical connection to receive incoming signals, and a transmitting optical connection to transmit outgoing signals. In some embodiments, the plurality of optical connections may include one or more separated optical connections, the separated optical connections corresponding to one or more multiplexing methods, for example, wavelength based multiplexing, fiber mode based multiplexing, polarization based multiplexing, and combinations thereof. In some embodiments, the first optical connection 106 may provide an optical coupling for optical signals to one or more additional systems, including additional computational systems, networks, remote computers, and any other suitable optical devices.

In some embodiments, a first redistribution layer (RDL) 112 may be formed on a backside of the substrate 101, while a second RDL 116 may be formed on the front side of the substrate 101. As used herein, the surface of the substrate 101 where the first PIC 110 is embedded is referred to as the front side, while the surface of the substrate 101 opposite the front side may be referred to as the backside. In some embodiments, one or more through-vias 114 may extend through the substrate 101 from the backside to the frontside. The one or more through-vias 114 may couple the first RDL 112 to the second RDL 116, and provide routing for electrical and data signals between the first RDL 112 and the second RDL 116.

The first RDL 112 may provide one or more layers including a series of pads, bumps, vias, through-vias, traces, and other forms of connection for redistributing electrical signals from connections on the backside of the substrate 101 to the one or more through-vias 114. The second RDL 116 may in turn provide one or more layers including a series of pads, bumps, vias, through-vias, traces, and other forms of connection for redistributing signals from connections to the one or more through-vias 114, the first PIC 110, the embedded bridge 108, the first device 102, and the second device 104.

In the exemplary embodiment of FIG. 1, the first device 102 and the second device 104 may be mounted upon the second RDL 116 using one or more conductive connections 118 and one or more dielectric bonds 120. The one or more conductive connections 118 may include pads, bumps, microbumps, pillars, balls, ball grids, microball arrays, and other forms such as C4 bumps, alone or in combination. The one or more dielectric bonds 120 may include a dielectric material or adhesive between the first device 102 and the second RDL 116, such as an epoxy, a resin, or other suitable material. In some embodiments, the one or more dielectric bonds 120 may be formed using an underfill technique and inserted between the first device 102 and the second RDL 116 and around the one or more conductive connections 118. In some embodiments, the one or more conductive connections 118 and the one or more dielectric bonds 120 may combine to form a hybrid bond between the first device 102 and the substrate 101.

In some embodiments, the substrate 101 may have a substrate interconnection 122 formed upon the first RDL 112. The substrate interconnection 122 may electrically connect the substrate 101 to a supporting substrate 130 such as an interposer, additional substrate, card, board, or some combination thereof. In some embodiments, the substrate interconnection 122 may include a conductive bond, a dielectric bond, or a hybrid bond. In some embodiments, a conductive bond may include pads, bumps, microbumps, pillars, balls, ball grids, microball arrays, and other forms such as C4 bumps, alone or in combination. In some embodiments, a dielectric bond may include a dielectric material such as silicon dioxide, resins, adhesives, and epoxies, alone or in combination. In some embodiments, the dielectric material may take the form of an underfill and be introduced between the substrate 101 and the supporting substrate 130 in conjunction with a conductive bond, and may form a hybrid bond between the substrate 101 and the supporting substrate 130.

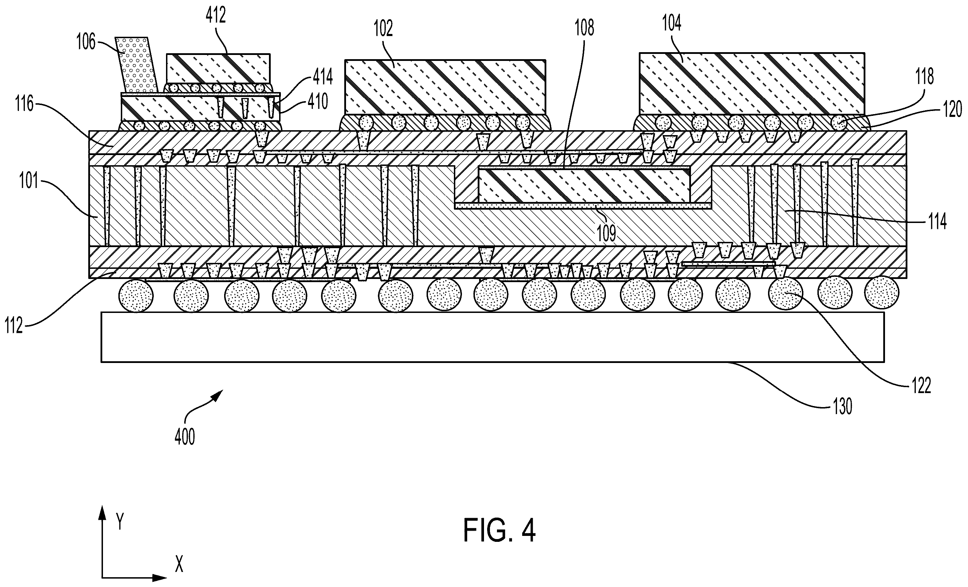

In some embodiments, the first device 102 may provide the driving electronics for the first PIC 110, and the first device 102 may provide heater control circuits, heater drivers, modulator drivers, and serializers to modify the optical signal within the first PIC 110. For example, if the first PIC 110 includes one or more micro-ring resonators, heaters may be integrated with the one or more micro-ring resonators to provide control over the resonance frequency of the one or more micro-ring resonators by altering the physical characteristics of the one or more micro-ring resonators. While portions of the heaters may be formed within the first PIC 110, the electronics controlling and regulating the heaters are within the first device 102 separate from the first PIC 110. Furthermore, the first PIC 110 may include one or more photodetectors to receive an optical signal, which may be transmitted to the first device 102 for further signal processing, including amplification, analog to digital conversion, rectification, or any other suitable signal processing techniques. In some embodiments, some or all of the driving electronics for the first PIC 110 may be transferred from the first device 102 to another device, such as the second device 104, alone or in combination with an additional driver EIC, as discussed further with respect to FIG.4.

FIG. 2 depicts a plan view of the device package architecture 100 according to an exemplary embodiment. FIG. 2 provides a plan view, with a first row 230 of elements corresponding with FIG. 1. FIG. 1 illustrates a cross-sectional view along the dashed line A-A' of FIG. 2. The exemplary embodiment of FIG. 2 provides for a second row 240 of elements formed parallel to the first row 230. The additional elements of the second row 240 may be formed such as discussed above with respect to the first row 230 of elements. While the exemplary embodiment of FIG. 2 depicts only a first row 230 and a second row 240, in some embodiments further rows may be inserted, for example a third row, a fourth row, etc.

In some embodiments, a second optical connection 206 may provide an optical connection to a second PIC 210. In some embodiments, the second optical connection 206 may be an optical connector, an optical fiber, a FAU, a pluggable optical connector, a plug connector, a v-groove, as well as combinations thereof and various arrays thereof. In some embodiments, additional optical elements may be placed between the second optical connection 206 and the second PIC 210, such as polarizers, gratings, anti-reflection coatings, filters, index matching coatings, lenses, and any other suitable optical components, alone or in a combination thereof. In some embodiments, the second optical connection 206 may allow the device package architecture 100 to transmit optical signals, to receive optical signals, or both receive and transmit optical signals. In some embodiments, the second optical connection 206 may include a plurality of optical connections, including a receiving optical connection to receive incoming signals, and a transmitting optical connection to transmit outgoing signals. In some embodiments, the plurality of optical connections may include one or more separated optical connections, the separated optical connections corresponding to one or more multiplexing methods, for example, wavelength-based multiplexing, fiber mode-based multiplexing, polarization-based multiplexing, and combinations thereof. In some embodiments, the second optical connection 206 may provide an optical coupling for optical signals to one or more additional systems, including additional computational systems, networks, remote computers, and any other suitable optical devices. In some embodiments, the first optical connection 106 and the second optical connection 206 may be independent of each other, while in some embodiments, the first optical connection 106 and the second optical connection 206 may have one function as a transmitter, and the other as receiver. In some embodiments, the first optical connection 106 and the second optical connection 206 may be optically coupled, and may be directly coupled, or coupled via one or more intermediate devices, systems or networks.

In some embodiments, the second PIC 210 may connect to a third device 202 and a fourth device 204 either directly or via a second embedded bridge 208. The second PIC 210, the third device 202, the fourth device 204, and the second embedded bridge 208 may take the same form as the first PIC 110, the first device 102, the second device 104, and the embedded bridge 108, as discussed above. In some embodiments, an interrow bridge 220 may connect the first row 230 and the second row 240 and provide for signal and power routing between the first row 230 and the second row 240. In some embodiments, the interrow bridge 220 may be a PIC, while in other embodiments, the interrow bridge 220 may be an EIC, a die, a passive bridge, or some other suitable element for forming a connection between two circuits, alone or a combination thereof. In some embodiments, where one or more additional rows of elements are added, one or more additional interrow bridges may be used to connect between the rows, while in other embodiments, a single interrow bridge may be used. In some embodiments, the interrow bridge 220 may be one or more bridges embedded within the substrate 101, and may be formed in series or in parallel between rows of elements.

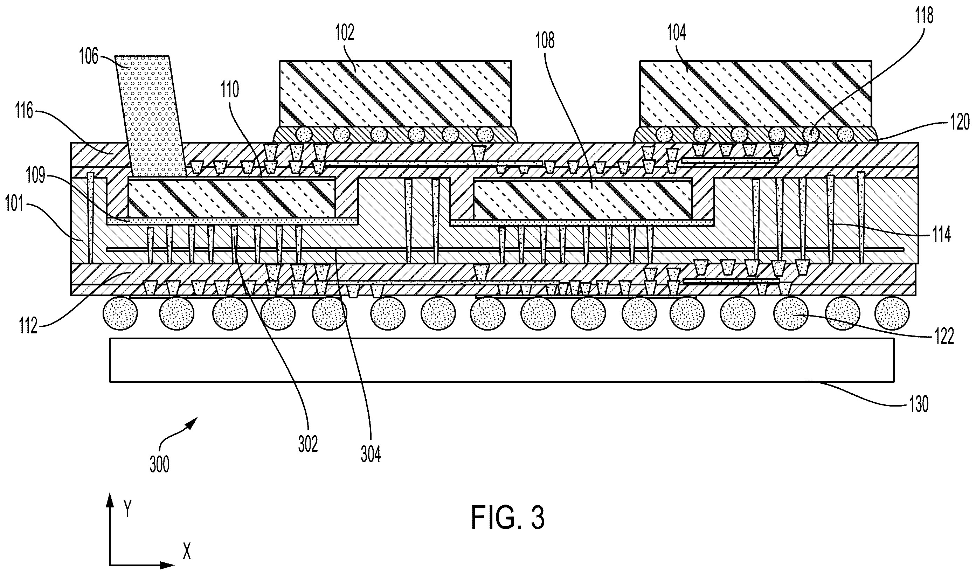

FIG. 3 depicts an illustrative embodiment of a second device package architecture 300. The second device package architecture 300 of FIG. 3 differs from the device package architecture 100 of FIG. 1, by including one or more additional thermal features embedded within the substrate 101. In some embodiments, the additional thermal features may include one or more thermal vias 302, one or more fluid cooling channels 304, and combinations thereof.

In some embodiments, the one or more thermal vias 302 may be formed in the backside of the substrate 101 and extend from the cavity containing the first PIC 110 or the embedded bridge 108. In some embodiments, the thermal vias 302 may be one or more through-vias, such as a TSV or TGV, depending on the material of the substrate 101. In some embodiments, the one or more thermal vias 302 may include a thermal conductive material within a through-via, such as metal like copper, silver, or aluminum, as well as additional materials suitable for use with a semiconductor process such as aluminum nitride, silicon carbide, or any other suitable thermal conductive material such as diamond, and combinations thereof. In some embodiments, the one or more thermal vias 302 may couple to additional structures for regulating heat, such as a thermal electric device, heat sinks, cooling pad, or other suitable structure. Additionally, in some embodiments, the one or more thermal vias 302 may couple with the one or more fluid cooling channels 304. In some embodiments, the one or more thermal vias 302 may contact the first PIC 110 or the embedded bridge 108, while in other embodiments the attach film 109 may be between the one or more thermal vias 302 and the first PIC 110 or the embedded bridge 108.

In some embodiments, the substrate 101 may include one or more fluid cooling channels 304. In some embodiments, the one or more fluid cooling channels 304 may comprise a channel formed within the substrate 101 for the passage of a fluid. In some embodiments, the fluid used within the one or more fluid cooling channels 304 may be a gas, such as air, nitrogen, argon, or other gas suitable for use within a semiconductor substrate. In some embodiments, the fluid used within the one or more fluid cooling channels 304 may be a liquid, such as water, aqueous solution, alcohols, glycol, and combinations thereof. In some embodiments, the one or more fluid cooling channels 304 may be formed directly in the substrate 101, while in other embodiments, the one or more fluid cooling channels 304 may include one or more layers between the substrate 101 and the fluid of the one or more fluid cooling channels 304. In some embodiments, the one or more layers may include a material such as a metal, ceramic, or other material to provide thermally conductive pathway between the fluid and the substrate 101. In some embodiments, the one or more layers may include a material layer to provide encapsulation and protection from corrosion or other damage from a fluid.

In some embodiments, the one or more thermal vias 302 may conduct heat into a fluid of the one or more fluid cooling channels 304, and heat may be transferred away from the one or more thermal vias 302 using convective heat transfer, conductive heat transfer, or a combination thereof. In some embodiments, the fluid may be actively sent, with a mechanism such as a pump or a fan, or any other suitable method of fluid transfer, to force the flow of the fluid, while in other embodiments, the fluid path may be shaped to allow passive flow of the fluid, or use any other mechanism for passive transport, for example, using a fluid experiencing a phase change. In some embodiments, the one or more fluid cooling channels 304 may be part of a closed loop cooling system, while in other embodiments, the one or more fluid cooling channels 304 may be part of an open loop system, while in yet other embodiments, the one or more fluid cooling channels 304 may transfer between an open loop and closed loop system. In some embodiments, a heat sink, heat exchanger, expander, compressor, cooling pad, thermal cooler, or any other suitable form of cooling, and combinations thereof may be coupled to the one or more fluid cooling channels 304 to provide cooling for the fluid of the one or more fluid cooling channels 304. In some embodiments, the heat transferred via the one or more fluid cooling channels 304 may be transferred to another fluid, or may be conducted to another surface. In some embodiments, a thermal dissipation structure may be used to provide cooling using a combination of radiative, conductive, and convective heat transfer. In some embodiments, a single one of the one or more fluid cooling channels 304 may provide cooling to all of the elements embedded within the substrate 101, while in other embodiments, each element may have a separate one of the one or more fluid cooling channels 304. In some embodiments, such as that illustrated in FIG. 2 where the second device package architecture 300 includes additional rows of elements, the one or more fluid cooling channels 304 may have one of the one or more fluid cooling channels 304 coupled to all of the elements embedded within the substrate 101, while in other embodiments, each element embedded within the one or more fluid cooling channels 304 may have a separate one of the one or more fluid cooling channels 304 to provide relief.

FIG. 4 depicts an exemplary embodiment of a third device package architecture 400. The third device package architecture 400 differs from the second device package architecture 300 of FIG. 3 and the device package architecture 100 of FIG. 1 by using a surface PIC 410 mounted on the surface of the substrate 101 in place of the first PIC 110 embedded within the substrate 101. In some embodiments, the surface PIC 410 may be mounted on the second RDL 116, while a driver EIC 412 may be mounted on the surface PIC 410. The surface PIC 410 may provide for the optical components necessary to receive or transmit signals via the first optical connection 106. In some embodiments, the driver EIC 412 may provide the driving electronics for driving the surface PIC 410, including heater control circuits, heater drivers, modulator drivers, and serializers to modify the optical signal within the surface PIC 410. For example, if the surface PIC 410 includes one or more micro-ring resonators, heaters may be integrated with the one or more micro-ring resonators to provide control over the resonance frequency of the one or more micro-ring resonators by altering the physical characteristics of the one or more micro-ring resonators. While portions of the heaters may be formed within the surface PIC 410, the electronics controlling and regulating the heaters are within the first device 102 separate from the surface PIC 410. Furthermore, the surface PIC 410 may include one or more photodetectors to receive an optical signal, which may be transmitted to the driver EIC 412 for further signal processing, including amplification, analog to digital conversion, rectification, or any other suitable signal processing techniques. In some embodiments, some or all of the driving electronics for the surface PIC 410 may be transferred from the driver EIC 412 to another device, such as the first device 102, alone or in combination with the driver EIC 412. In some embodiments, the driver EIC 412 may connect to the second RDL 116 via one or more vias 414 through the surface PIC 410. In some embodiments, a 3D stack of the surface PIC 410 and the driver EIC 412 may be formed prior to mounting the surface PIC 410 on the substrate 101. In some embodiments, the surface PIC 410 and the driver EIC 412 may be mounted in a flip chip configuration with the driver EIC 412 in contact with the substrate 101 and the surface PIC 410 mounted upon the driver EIC 412, while in other embodiments, different configurations may be used. The driver EIC 412 may be mounted to the surface PIC 410 using a conductive connection including pads, bumps, microbumps, pillars, balls, ball grids, microball arrays, and other forms such as C4 bumps, alone or in combination. In some embodiments, a dielectric connection may be included, and may take the form of an underfill, adhesive, resin, epoxy or other dielectric material between the driver EIC 412 and the surface PIC 410. The surface PIC 410 may be mounted to the substrate 101 using a conductive connection including pads, bumps, microbumps, pillars, balls, ball grids, microball arrays, and other forms such as C4 bumps, alone or in combination. In some embodiments, a dielectric connection may be included, and may take the form of an underfill, adhesive, resin, epoxy or other dielectric material between the surface PIC 410 and the substrate 101.

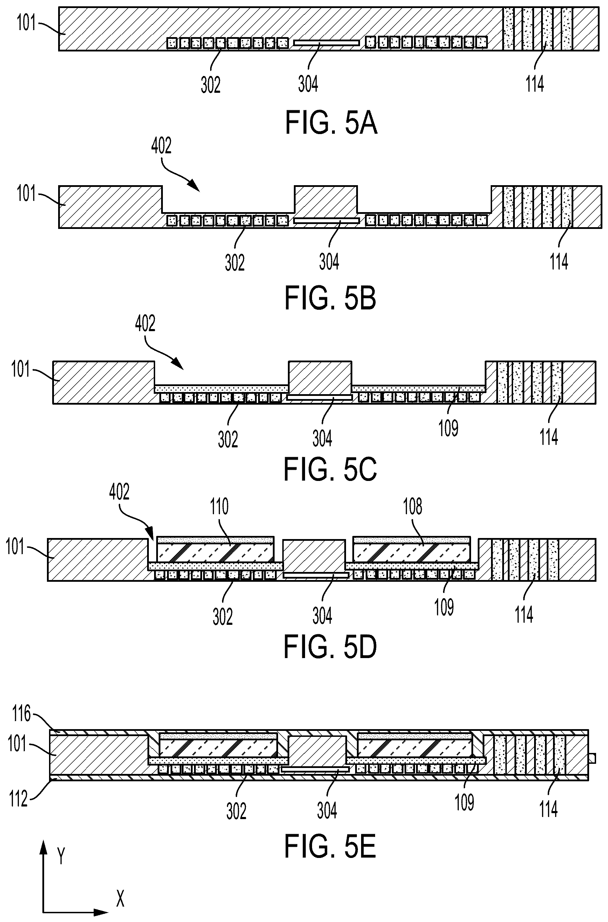

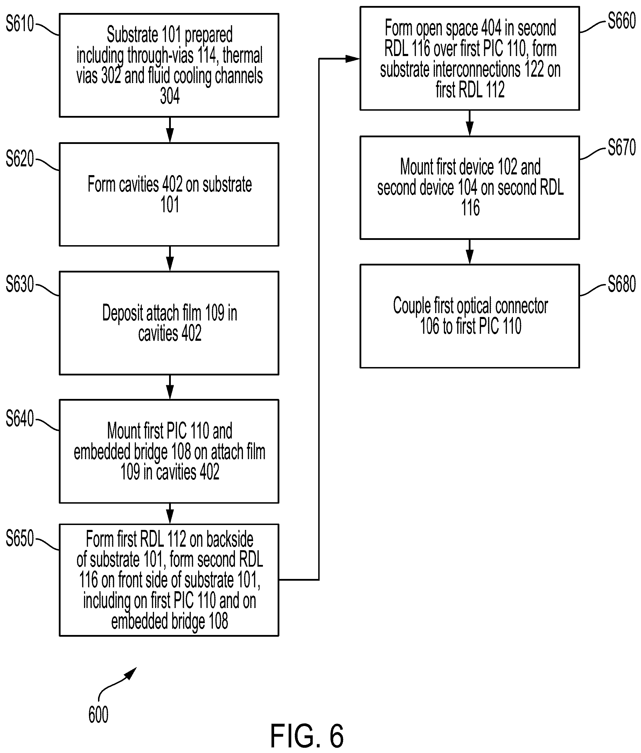

FIGS. 5A-5H depict an illustrative embodiment of a process of forming a device package architecture such as the device package architecture 100, or any other device package architectures shown herein. FIG. 6 depicts an example embodiment of a process 600 for forming a device package assembly corresponding to the illustrative embodiment of FIGS. 5A-5H.

FIG. 5A depicts at S610 in FIG. 6 where the substrate 101 is prepared. The substrate 101 may be formed of glass or a semiconductor such as silicon, or a combination thereof. In some embodiments, the substrate 101 may have the one or more through-vias 114 formed within, the one or more through-vias 114 extending between a first side and a second side of the substrate 101. In some embodiments, the one or more through-vias 114 may be formed using drilling, laser milling, etching, or any other suitable process, and combinations thereof. In some embodiments, the one or more through-vias 114 may include a conductive material formed within the one or more through-vias 114, such as a metal plug, and may include materials such as copper, aluminum, titanium, tungsten, and combinations thereof. In some embodiments, the conductive material may be formed by a physical vapor deposition (PVD) process, a chemical vapor deposition (CVD) process, an atomic layer deposition (ALD) process, electrowetting, electroplating, or any other suitable technique. In some embodiments, one or more materials may be deposited to form a liner layer prior to bulk deposition, while in other embodiments, the conductor may be deposited directly on the substrate 101.

In some embodiments, the one or more thermal vias 302, the one or more fluid cooling channels 304, or a combination thereof may be formed in the substrate 101 during the preparation of the substrate 101 at S610. In some embodiments, the one or more thermal vias 302, the one or more fluid cooling channels 304, or a combination thereof may be formed by first forming one or more openings within the substrate 101, the openings may be formed using drilling, laser milling, etching, or any other suitable process, and combinations thereof. In some embodiments, the one or more thermal vias 302, the one or more fluid cooling channels 304, or a combination thereof may then be partially or completely filled using a thermal conductive material such as one or more layers of metals, carbides or nitrides. In some embodiments, the one or more fluid cooling channels 304 may be partially formed within the substrate 101, and may include one or more parts formed on the substrate 101. For example, an open channel may be formed within the substrate 101, with a lid mounted upon the substrate 101 to cover the open channel. In other embodiments, any suitable technique may be used to form the one or more fluid cooling channels 304 within the substrate 101. In some embodiments, the one or more thermal vias 302 may be formed to a specified depth within the substrate 101 to couple with embedded devices, while in other embodiments, the depth may be larger or smaller. In some embodiments, the one or more thermal vias 302 and the one or more fluid cooling channels 304 may be formed within the same layer of the substrate 101. In other embodiments the one or more fluid cooling channels 304 may be formed above or below the one or more thermal vias 302.

FIG. 5B depicts at S620 in FIG. 6 where one or more cavities 402 are formed in the substrate 101. In some embodiments, the one or more cavities 402 may be formed using a variety of techniques, such as laser milling, drilling, etching, or any other suitable process either alone or in combination. In some embodiments, the one or more cavities 402 may be formed to a depth intersecting the one or more thermal vias 302, while in other embodiments, the depth may be larger or smaller. In some embodiments, the one or more cavities 402 may be formed to a uniform depth, while in other embodiments, the one or more cavities 402 may vary in depth within each cavity, between each cavity, or a combination thereof. In some embodiments, the one or more cavities 402 may be formed to a depth such that the first PIC 110 or the embedded bridge 108 may be mounted within a corresponding cavity such that a surface of the first PIC 110 or the embedded bridge 108 may be coplanar with a surface of the substrate 101, while in other embodiments, the surface of the surface of the first PIC 110 or the embedded bridge 108 may be above or below a corresponding surface of the substrate 101.

FIG. 5C depicts at S630 in FIG. 6 where the attach film 109 is deposited within the one or more cavities 402. In some embodiments, the attach film 109 may be formed from an adhesive material such as a resin or epoxy, a metal layer, a dielectric material, and any other suitable material to form one or more layers to allow the first PIC 110 or the embedded bridge 108 to attach to the substrate 101. In some embodiments, the attach film 109 may formed using a process such as CVD, PVD, ALD, or any other suitable process. In some embodiments, the attach film 109 may be the same material in each of the one or more cavities 402, while in other embodiments, the material of the attach film 109 may vary between the one or more cavities 402. In some embodiments, the attach film 109 may be formed to a uniform depth in each of the one or more cavities 402, while in some embodiments, the depth may vary within each of the one or more cavities 402, or the depth may vary between each of the one or more cavities 402.

FIG. 5D depicts at S640 in FIG. 6 where the first PIC 110 and the embedded bridge 108 are mounted on the attach film 109 within the one or more cavities 402. In some embodiments, the first PIC 110 and the embedded bridge 108 may be mounted such that a surface of the first PIC 110 or the embedded bridge 108 may be coplanar with a surface of the substrate 101, while in other embodiments, the surface of the surface of the first PIC 110 or the embedded bridge 108 may be above or below a corresponding surface of the substrate 101. In some embodiments, the embedded bridge 108 may comprise a second PIC, while in other embodiments the embedded bridge may be formed using a semiconductor substrate, such as a silicon die. In some embodiments, the first PIC 110 or the embedded bridge 108 may have the attach film 109 form a bond between the first PIC 110 or the embedded bridge 108 and the substrate 101. In some embodiments, the substrate 101 may be further treated to bond the first PIC 110 or the embedded bridge 108 to the substrate 101, and may include the use of thermal energy or radiation energy to form a bond, such as by curing an epoxy or resin within the attach film 109.

FIG. 5E depicts at S650 in FIG. 6 where the first RDL 112 and the second RDL 116 are formed on the substrate 101. The first RDL 112 and the second RDL 116 may include one or more layers including a series of pads, bumps, vias, through-vias, traces, and other forms of connection for redistributing signals. In some embodiments, the first RDL 112 and the second RDL 116 may be formed directly on a surface of the substrate 101, while in some embodiments one or more build up layers may be formed to create a planar surface which the first RDL 112 and the second RDL 116 may be formed upon. In some embodiments, the buildup layer may include one or more materials including molding compounds, resins, epoxies, dielectric material, and other suitable materials for use with the substrate 101. In some embodiments, the second RDL 116 may be formed over the one or more cavities 402, and may be coupled to the first PIC 110 and the embedded bridge 108. In some embodiments, the first RDL 112 and the second RDL 116 may be formed using a variety of techniques to form and pattern conductive layers, including the deposition of one or more materials using PVD, CVD, ALD, or other suitable techniques. The materials may be further patterned using techniques such as lithography, etching, grinding, milling, ablation, to selectively remove potions of the materials, while in other embodiments, techniques such as using a photoresist mask may be used to selectively deposit materials. In some embodiments, the materials may include conductive materials such as metals, as well as dielectric materials such as nitrides and oxides. In some embodiments, the first RDL 112 and the second RDL 116 may be formed in parallel, while in other embodiments, the first RDL 112 and the second RDL 116 may be formed sequentially, or in a combination of parallel and sequential steps.

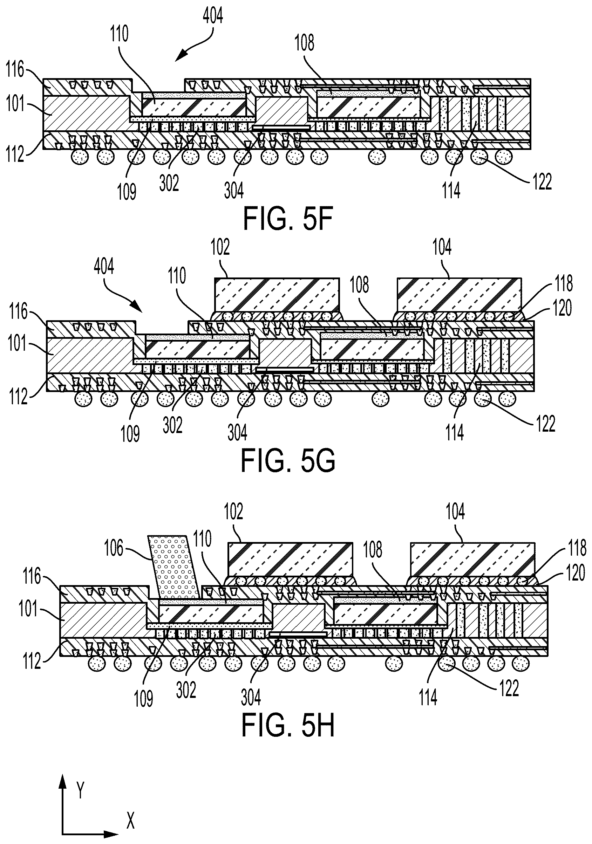

FIG. 5F depicts at S660 in FIG. 6 where an open space 404 may be formed in the second RDL 116 over the first PIC 110. In some embodiments, the open space 404 may be formed using a method such as lithography, etching, milling or any other suitable method to remove a portion of material in the second RDL 116. In some embodiments, the open space 404 may be formed during the formation of the second RDL 116 at S650, while in other embodiments, the open space 404 may be formed after the second RDL 116 is formed. In some embodiments, the open space 404 may expose a top surface of the first PIC 110, while in other embodiments, the open space 404 may expose a side surface or bottom surface of the first PIC 110. In some embodiments, the open space 404 may be formed to expose one or more additional optical elements embedded in the substrate 101, for example a thin optical film, a filter, or a waveguide coupled to the first PIC 110.

Additionally, at S660, the substrate interconnection 122 may be formed upon the first RDL 112. In some embodiments, the substrate interconnection 122 may include a conductive interconnection, a dielectric interconnection, or a hybrid interconnection. In some embodiments, a conductive interconnection may include pads, bumps, microbumps, pillars, balls, ball grids, microball arrays, and other forms such as C4 bumps, alone or in combination. In some embodiments, a dielectric interconnection may include a dielectric material such as silicon dioxide, resins, adhesives, and epoxies, alone or in combination. In some embodiments, the dielectric material may take the form of an underfill and be introduced between the substrate 101 and the supporting substrate 130 in conjunction with a conductive interconnection, and may form a hybrid connection between the substrate 101 and the supporting substrate 130. In some embodiments, the substrate interconnection 122 may electrically connect the substrate 101 to the supporting substrate 130 such as an interposer, additional substrate, card, board, or some combination thereof. In some embodiments, the substrate interconnection 122 may be fully formed at S660, mounting the substrate 101 on the supporting substrate 130, while in other embodiments, the substrate interconnection 122 may be only partially formed at S660, such as forming a conductive ball grid array suitable for later mounting of the substrate 101 on the supporting substrate 130.

FIG. 5G depicts at S670 in FIG. 6 where the first device 102 and the second device 104 may be mount on the substrate 101, upon the second RDL 116. In some embodiments, the first device 102 and the second device 104 may be mounted upon the second RDL 116 using one or more conductive connections 118 and one or more dielectric bonds 120. The one or more conductive connections 118 may include pads, bumps, microbumps, pillars, balls, ball grids, microball arrays, and other forms such as C4 bumps, alone or in combination. The one or more dielectric bonds 120 may include a dielectric material or adhesive between the first device 102 and the second RDL 116, such as an epoxy, a resin, or other suitable material. In some embodiments, the one or more dielectric bonds 120 may be formed using an underfill technique and inserted between the first device 102 and the second RDL 116 and around the one or more conductive connections 118. In some embodiments, the one or more conductive connections 118 and the one or more dielectric bonds 120 may combine to form a hybrid bond between the first device 102 and the substrate 101.

FIG. 5H depicts at S680 in FIG. 6 where the first optical connection 106 is coupled to the first PIC 110 using the open space 404 within the second RDL 116. In some embodiments, the first optical connection 106 may take the form of an optical connector, a FAU, a pluggable optical connector, a plug connector, a v-groove, as well as combinations thereof and various arrays thereof. In some embodiments, additional optical elements may be placed between the first optical connection 106 and the first PIC 110, such as polarizers, gratings, anti-reflection coatings, filters, index matching coatings, lenses, and any other suitable optical components, alone or in a combination thereof. In some embodiments, the first optical connection 106 may be permanently attached to the first PIC 110, while in other embodiments the first optical connection 106 may be removably attached to the first PIC 110.

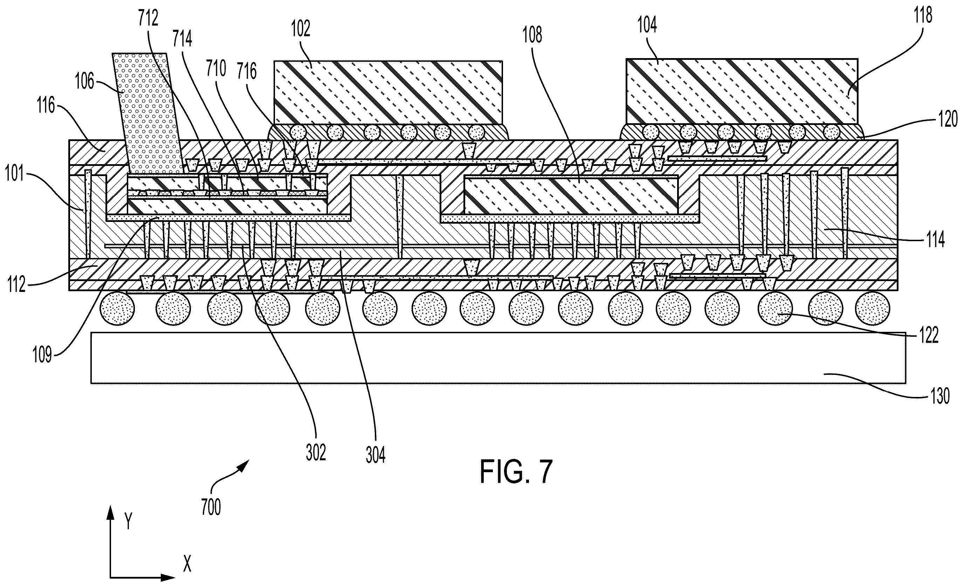

FIG. 7 depicts an exemplary embodiment of a fourth device package architecture 700. The fourth device package architecture 700 differs from the device package architecture 100 of FIG. 1 and the second device package architecture 300 of FIG. 3 by featuring an embedded PIC 710 mounted on an embedded EIC 712. The embedded PIC 710 may be connected to the first optical connection 106 via an open area in the second RDL 116. In some embodiments, the embedded EIC 712 may be mounted on the attach film 109, and may be thermally coupled to the one or more thermal vias 302 and the one or more fluid cooling channels 304. In some embodiments, the embedded PIC 710 may be mounted on the embedded EIC 712 using one or more embedded interconnections 714. In some embodiments, the one or more embedded interconnections 714 may include a conductive interconnection, a dielectric interconnection, or a hybrid interconnection. In some embodiments, a conductive interconnection may include pads, bumps, microbumps, pillars, balls, ball grids, microball arrays, and other forms such as C4 bumps, alone or in combination. In some embodiments, a dielectric interconnection may include a dielectric material such as silicon dioxide, resins, adhesives, and epoxies, alone or in combination. In some embodiments, the dielectric material may take the form of an underfill and be introduced between the embedded EIC 712 and the embedded PIC 710 in conjunction with a conductive interconnection, and may form a hybrid connection between the embedded EIC 712 and the embedded PIC 710. In some embodiments, the placement of the embedded EIC 712 may reduce the distance for signals to travel between the embedded EIC 712 and the embedded PIC 710, and may thus increase the efficiency and latency. In some embodiments, one or more trans-PIC vias 716 may extend through the embedded PIC 710, and may form an electrical connection between the embedded EIC 712 and the second RDL 116. In some embodiments, the embedded EIC 712 may use additional coupling methods such as routing around the embedded PIC 710, or routing using a via to connect to the first RDL 112 which is then routed to the second RDL 116.

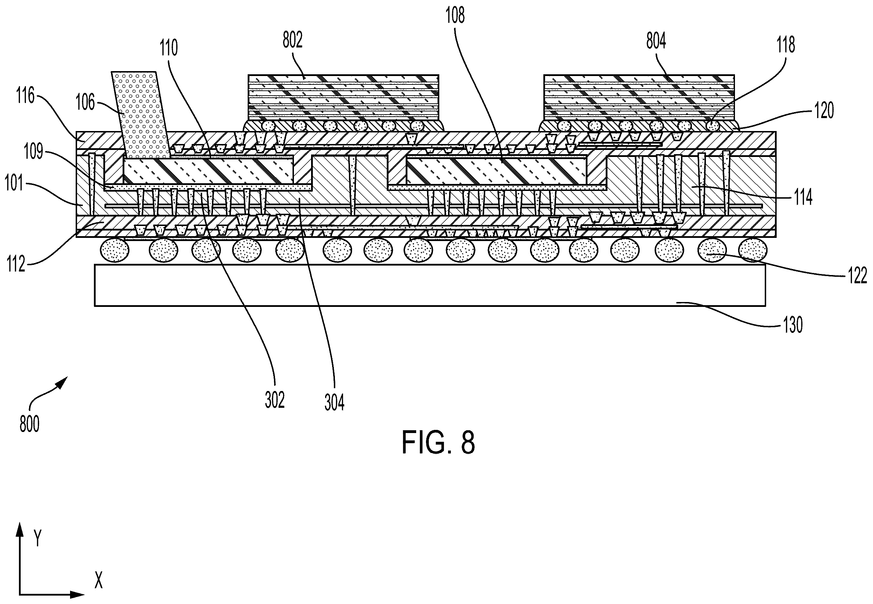

FIG. 8 depicts an exemplary embodiment of a fifth device package architecture 800. The fifth device package architecture 800 differs from the device package architecture 100 of FIG. 1 and the second device package architecture 300 of FIG. 3 by featuring a first device stack 802 and a second device stack 804 in place of the first device 102 and the second device 104. In some embodiments the first device stack 802 and the second device stack 804 may each comprise a stack of one or more component devices. In some embodiments, the stack of component devices may include memory devices, core devices, and combinations thereof. In some embodiments, the devices may include a core device, for example a processor, processing device, or other form of microcontroller to act as a controller. In some embodiments, the first device stack 802 and the second device stack 804 may comprise HBM, and may include one or more memory devices stacked on top of each other and on top of a base die providing a core processor. In some embodiments, one or more trans-stack vias may connect devices within a device stack together. While the exemplary embodiment of FIG. 8 depicts only the first device stack 802 and the second device stack 804, the device package architecture may include additional devices, for example, as discussed with respect to FIG. 2 above.

While this specification may contain many specific implementation details, the implementation details should not be construed as limitations on the scope of any claimed subject matter, but rather be construed as descriptions of features specific to particular embodiments. Certain features that are described in this specification in the context of separate embodiments may also be implemented in combination in a single embodiment. Conversely, various features that are described in the context of a single embodiment may also be implemented in multiple embodiments separately or in any suitable subcombination. Moreover, although features may be described above as acting in certain combinations and even initially claimed as such, one or more features from a claimed combination may in some cases be excised from the combination, and the claimed combination may be directed to a subcombination or variation of a subcombination.

Similarly, while operations are depicted in the drawings in a particular order, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system components in the embodiments described above should not be understood as requiring such separation in all embodiments, and it should be understood that the described program components and systems can generally be integrated together in a single software product or packaged into multiple software products.

Thus, particular embodiments of the subject matter have been described herein. Other embodiments are within the scope of the following claims. In some cases, the actions set forth in the claims may be performed in a different order and still achieve desirable results. Additionally, the processes depicted in the accompanying figures do not necessarily require the particular order shown, or sequential order, to achieve desirable results. In certain implementations, multitasking and parallel processing may be advantageous.

## Claims

1. A device comprising:
a substrate (101) having a first attachment location and a second attachment location;
a first photonic integrated circuit (110; 710) mounted within the first attachment location;
a bridge (108) mounted within the second attachment location; and
a first compute device (102; 802) mounted on the substrate (101) and at least partially over the first attachment location and the second attachment location.

2. The device of claim 1, further comprising a second compute device (104; 804) mounted on the substrate (101) at least partially over the second attachment location, wherein the second compute device (104; 804) is electrically connected to the first compute device (102; 802) by the bridge (108).

3. The device of claim 1 or 2, wherein the first compute device (102; 802) includes at least one selected from the group consisting of a memory device and a processing device.

4. The device of any one of claims 1 to 3, wherein a redistribution layer (116) is arranged between the first photonic integrated circuit (110; 710) and the first compute device (102; 802), and wherein an optical fiber connection extends from the first photonic integrated circuit (110) through the redistribution layer (116).

5. The device of any one of claims 1 to 4, wherein the substrate (101) comprises at least one selected from the group consisting of glass and silicon.

6. The device of any one of claims 1 to 5, wherein the first photonic integrated circuit (110) includes a plug connector configured to receive a bi-directional optical fiber,
wherein the bi-directional optical fiber is configured to transmit an incoming optical signal to the first photonic integrated circuit (110), and
wherein the bi-directional optical fiber is configured to transmit an outgoing optical signal from the first photonic integrated circuit (110).

7. The device of any one of claims 1 to 6, further comprising:
a fluid cooling channel (304) formed within the substrate (101); and
a thermal via (302) formed between the first attachment location and a surface of the substrate (101),
wherein the thermal via (302) thermally couples the first photonic integrated circuit (110) to the fluid cooling channel (304).

8. The device of any one of claims 1 to 7, wherein the bridge (108) is a second photonic integrated circuit.

9. A system comprising:
a substrate (101) having a first side and a second side opposite the first side, the first side having a first attachment location and a second attachment location;
a photonic integrated circuit (110) at least partially within the first attachment location;
a bridge (108) at least partially within the second attachment location;
a first compute device (102) mounted on the first side of the substrate (101); and
a first thermal via (302) within the substrate (101), the first thermal via (302) extending from the second side to the first attachment location.

10. The system of claim 9, further comprising a second compute device (104) mounted on the first side of the substrate (101),
wherein the second compute device (104) is coupled to the first compute device (102) via the bridge (108).

11. The system of claim 9 or 10, further comprising an attach film (109) between the first thermal via (302) and the photonic integrated circuit (110).

12. The system of any one of claims 9 to 11, further comprising:
a second thermal via (302) within the substrate (101), wherein the second thermal via (302) extends from the second side to the second attachment location; and
an attach film (109) between the second thermal via (302) and the bridge (108).

13. The system of any one of claims 9 to 12, further comprising a fluid cooling channel (304) within the substrate (101) and thermally coupled to the first thermal via (302).

14. The system of any one of claims 9 to 13, further comprising a redistribution layer (116) arranged between the photonic integrated circuit (110) and the first compute device (102); and
an optical fiber connection extending between a surface of the first side of the substrate (101) and a surface of the photonic integrated circuit (110) parallel to the first side.

15. The system of claim 9, wherein the first compute device (102) is mounted at least partially over the first attachment location and the second attachment location.
